# EUROPÄISCHE PATENTSCHRIFT

(11) **EP 1 443 014 B1**
(45) Veröffentlichungstag und Bekanntmachung des Hinweises auf die Patenterteilung: **19.03.2008**
(21) Anmeldenummer: 04001348.4
(22) Anmeldetag: 22.01.2004
(51) Int. Cl.: B66F 9/24, H01L 23/34, B62D 51/00, B62D 1/14

(54) **Steuerelektronik für ein Flurförderzeug, insbesondere deichselgeführtes Flurförderzeug**
Electronic control for industrial truck, especially towbar guided industrial truck
Commande électronique pour chariot de manutention, en particulier chariot de manutention guidé par timon

(30) Priorität: 31.01.2003 DE 10303950
(43) Veröffentlichungstag der Anmeldung: 04.08.2004
(73) Patentinhaber: OM Carrelli Elevatori S.p.A., 20020 Lainate (MI) (IT)
(72) Erfinder: Accorsi, Marco, 46023 Gonzaga (MN) (IT)
(74) Vertreter: Geirhos, Johann

(56) Entgegenhaltungen:
- DE-A- 3 402 116
- DE-A- 4 444 772
- GB-A- 1 187 595
- US-A1- 2002 030 239

## Beschreibung

Die Erfindung betrifft eine Steuerelektronik für ein Flurförderzeug, die elektrische und/oder elektronische Bauelemente und/oder Signalgeber umfasst, wobei die Steuerelektronik mit einer integrierten Heinzeinrichtung versehen ist, die einen Betrieb der Steuerelektronik innerhalb eines Temepraturbereichs sicherstellt.

Eine derartige Steuerelektronik wird bei Flurförderzeugen eingesetzt, um die von einer Bedienperson an Bedienungselementen, beispielsweise Joysticks, Schaltern, Tastern, oder Druckknöpfen vorgegebenen Befehle in Steuersignale zur Ansteuerung der Antriebe, beispielsweise einem Fahrantrieb und einem Hub- sowie gegebenenfalls einem Neigeantrieb, zur Steuerung einer Warneinrichtung, beispielsweise einer Hupe, und zur Betätigung einer Sicherheitseinrichtung umzuwandeln.

Bei deichselgeführten Flurförderzeugen wird üblicherweise die Steuerelektronik im Deichselkopf angeordnet, an dem alle Bedienungselementen für das Flurförderzeug ausgebildet sind. Ein derartiges Flurförderzeug mit einer im Deichselkopf angeordneten Steuerelektronik, an der elektrische und/oder elektronische Bauelemente und Signalgeber angeordnet sind, die mit den Bedienungselementen in Wirkverbindung stehen, ist in der DE 44 44 772 A1 beschrieben.

Bei Flurförderzeugen, die bei niedrigen Umgebungstemperaturen oder bei Umgebungsbedingungen mit hohen Temperaturschwankungen, beispielsweise innerhalb Kühlhäusern, betrieben werden, kann es zur Bildung von Kondenswasser an oder auf der Steuerelektronik kommen, die zu Schäden oder einem Ausfall der Steuerelektronik und somit zu einem Ausfall des Flurförderzeugs führen kann. Hohe Temperaturschwankungen können bei der Steuerelektronik auch zu einer Verkürzung der Lebensdauer führen. Diese Umgebungstemperatureinflüsse treten verstärkt bei deichselgeführten Flurförderzeugen auf, bei denen die Steuerelektronik im Deichselkopf und somit getrennt von den elektrischen Antrieben angeordnet ist, die im Betrieb eine gewisse Abwärme erzeugen.

Bei Flurförderzeugen für Kühlhäuser, sogenannten Cold-Storage-Ausführungen von Flurförderzeugen, ist es bekannt, eine separate Zusatzheizung für die Steuerelektronik vorzusehen. Eine Zusatzheizung weist jedoch einen hohen zusätzlichen Bauaufwand und somit hohe zusätzliche Kosten auf. Zudem sind Flurförderzeuge bekannt, bei denen die Steuerelektronik abgedichtet und somit gekapselt ist, um das Entstehen von Kondenswasser bei niedrigen Umgebungsbedingungen zu vermeiden. Eine derartige gekapselte Steuerelektronik weist jedoch ebenfalls einen hohen zusätzlichen Bauaufwand auf. Aufgrund der beengten Platzverhältnisse in einem Deichselkopf mit integrierter Steuerelektronik ist eine Zusatzheizung und eine gekapselte Steuerelektronik nur mit hohem zusätzlichen Bauaufwand bei deichselgeführten Flurförderzeugen realisierbar. Darüber hinaus sind bei Flurförderzeugen Widerstandsheizungen für die Steuerelektronik bekannt, bei denen über einen zusätzlichen Widerstand an der Steuerelektronik ein Aufheizen der Steuerelektronik erzielt werden kann. Eine derartige Widerstandsheizung erfordert jedoch mit dem Widerstand ein separates Bauelement. Zudem bildet der Widerstand eine punktuelle Wärmequelle, wodurch eine gleichmäßige Aufheizung der Steuerelektronik nicht erzielt werden kann.

Aus der US-A1-2002/0030239 ist eine gattungsgemäße Steuerelektronik, gemäß dem Oberbegriff des Anspruchs 1 für ein Fahrzeug bekannt. Die Steuerelektronik weist eine integrierte Heizeinrichtung auf, wobei die Heizeinrichtung von elektronischen Bauelementenen gebildet ist, die Dummy-Arbeitszyklen ausführen, um einen Betrieb der Steuerelektronik innerhalb eines Temperaturbereichs sicherzustellen.

Der vorliegenden Erfindung liegt die Aufgabe zugrunde, eine Steuerelektronik für ein Flurförderzeug zur Verfügung zu stellen, die mit geringem Aufwand und geringen zusätzlichen Kosten wirksam beheizt werden kann.

Diese Aufgabe wird erfindungsgemäß dadurch gelöst, dass die Steuerelektronik mit einem an eine Spannungsquelle, insbesondere eine Batterie, angeschlossenen Spannungswandler versehen ist, der die Heizeinrichtung bildet. Erfindungsgemäß ist somit in die Steuerelektronik eine von dem Spannungswandler gebildete Heizeinrichtung integriert, mit der ein Betrieb der Steuerelektronik bei einer bestimmten nahezu konstanten Temperatur bzw. innerhalb eines bestimmten Temperaturbereichs sichergestellt wird. Durch den Betrieb der Steuerelektronik bei nahezu konstanter Temperatur wird das Entstehen von Kondenswasser an der Steuerelektronik bei Flurförderzeugen vermieden, die unter hohen Temperaturschwankungen oder bei niedrigen Umgebungstemperaturen, beispielsweise innerhalb Kühlhäusern, betrieben werden. Hierdurch kann eine hohe Betriebsfähigkeit und Sicherheit gegen Ausfall der Steuerelektronik und somit des Flurförderzeugs erzielt werden. Durch den Betrieb der Steuerelektronik bei konstanten Temperaturbedingungen wird zudem eine erhöhte Lebensdauer der Steuerelektronik erzielt. Bei batteriebetriebenen Flurförderzeugen ist ein Spannungswandler, insbesondere ein Gleichspannungswandler, erforderlich, der die Batteriespannung, beispielsweise 24V, auf ein niedrigeres Spannungsniveau von beispielsweise 5V zur Versorgung der Steuerelektronik reduziert. Durch die erfindungsgemäße Verwendung dieses Spannungswandlers als Heizelement, das die Heizleistung zum Aufheizen der Steuerelektronik liefert, auf eine im wesentlichen konstante Temperatur ist keine zusätzliche Heizeinrichtung erforderlich, wodurch sich ein geringer Bauaufwand ergibt.

Bei einer bevorzugten Ausgestaltungsform der Erfindung, wobei die Steuerelektronik als Platine mit mehreren Leiterplattenschichten ausgebildet ist, ergeben sich besondere Vorteile, wenn die Platine zumindest eine zwischen einer oberen Leiterplattenschicht und einer unteren Leiterplattenschicht angeordnete Zwischenleiterplattenschicht aufweist, die zur Aufheizung der Platine mit dem Spannungswandler in Verbindung steht. Durch die Einleitung der Heizleistung des Spannungswandler in die Zwischenleiterplattenschicht wird auf einfache Weise eine gleichmäßige Wärmeeinleitung und Wärmeverteilung über die gesamte Platine und somit eine gleichmäßige Erwärmung der Platine erzielt.

Zweckmäßigerweise steht hierzu der Spannungswandler mittels Verbindungsmitteln mit der Zwischenleiterplattenschicht in Verbindung. Der an der oberen Leiterplattenschicht angeordnete Spannungswandler kann hierdurch auf einfache Weise zum Aufheizen mit der Zwischenleiterplattenschicht verbunden werden.

Die Verbindungsmittel sind mit besonderem Vorteil als zumindest ein elektrischer Leiter ausgebildet, der mit einer Leiterbahn der Zwischenleiterplattenschicht in Verbindung steht. Die von dem Spannungswandler erzeugte Heizleistung kann somit auf einfache Weise in die inneren Leiterbahnen der Platine der Zwischenleiterplattenschicht eingebracht und über die Zwischenleiterplattenschicht verteilt werden, wodurch eine gleichmäßige Aufheizung der Zwischenleiterplattenschicht und somit der gesamten Platine erzielt wird.

Der elektrische Leiter kann gemäß einer bevorzugten Ausgestaltungsform der Erfindung als metallisches Rohr mit einer Kupferfüllung ausgebildet sein.

Ein Betrieb der Steuerelektronik bei einer bestimmten Temperatur bzw. innerhalb eines bestimmten Temperaturbereichs wird auf einfache Weise sichergestellt, wenn gemäß einer Weiterbildung der Erfindung zur Steuerung der von dem Spannungswandler gebildeten Heizeinrichtung ein Temperatursensor vorgesehen ist

Als Temperatursensor kann gemäß einer vorteilhaften Ausgestaltungsform der Erfindung ein PTC-Sensor (Positive Temperature Coefizient) verwendet werden, der an der Platine angeordnet ist. Mit einem PTC-Sensor, dessen Widerstand bezüglich einer Bezugstemperatur bei steigenden Temperaturen steigt bzw. bei sinkenden Temperaturen fällt, kann eine Widerstandsänderung bezüglich eines bestimmten Temperaturwertes, bei dem die Steuerelektronik betrieben wird, auf einfache Weise ermittelt werden und zur Steuerung der Heizleistung des Spannungswandlers verwendet werden. Der Spannungswandler als Heizeinrichtung und der PTC-Sensor als Temperatursensor sind hierbei auf der Platine angeordnet und somit in der Steuerelektronik integriert.

Als Temperatursensor kann ebenfalls ein NTC-Sensor (Negative Temperature Coefizient) oder ein anderer geeigneter Temperatursensor verwendet werden.

Sofern der PTC-Sensor gemäß einer bevorzugten Ausgestaltungsform der Erfindung mit zumindest einem Lastwiderstand in Reihe geschalten ist, kann auf einfache Weise ein Stromänderung erzeugt werden, mit der eine Anpassung der Leistung und somit der Heizleistung des Spannungswandlers erzielt werden kann.

Der PTC-Sensor ist hierbei zweckmäßigerweise über den Lastwiderstand an die mit der von dem Spannungswandler erzeugten Spannung beaufschlagten elektrischen Leiterbahn angeschlossen. Hierdurch kann über die Stromänderung die Heizleistung des Spannungswandlers verändert werden und somit die Steuerelektronik in Abhängigkeit von der an dem PTC-Sensor ermittelten Temperatur beheizt werden.

Besondere Vorteile ergeben sich bei der Anordnung der Steuerelektronik in einem Deichselkopf eines deichselgeführten Flurförderzeugs. Die erfindungsgemäße Heizeinrichtung, die zusammen mit dem Temperatursensor zur Regulierung der Heizleistung vollständig in der Platine der Steuerelektronik integriert ist, benötigt keinen zusätzlichen Bauraum innerhalb des Deichselkopfes. Durch die Heizeinrichtung wird ein Betrieb der Steuerelektronik bei einer bestimmten Temperatur und somit eine erhöhte Lebensdauer der Steuerelektronik mit geringem zusätzlichen Bauaufwand und somit geringen zusätzlichen Kosten erzielt. Durch die geringen zusätzlichen Kosten kann diese Steuerelektronik als Standard verwendet werden, wodurch für deichselgeführte Flurförderzeuge für Kühlhausanwendungen (Cold-Storage-Ausführungen) keine veränderte Steuerelektronik mit hohen zusätzlichen Kosten erforderlich ist.

Weitere Vorteile und Einzelheiten der Erfindung werden anhand des in den schematischen Figuren dargestellten Ausführungsbeispiels näher erläutert.

Hierbei zeigt
- Figur 1: eine Draufsicht auf eine erfindungsgemäße Steuerelektronik und
- Figur 2: einen Schnitt entlang der Linie A-A in Figur 1.

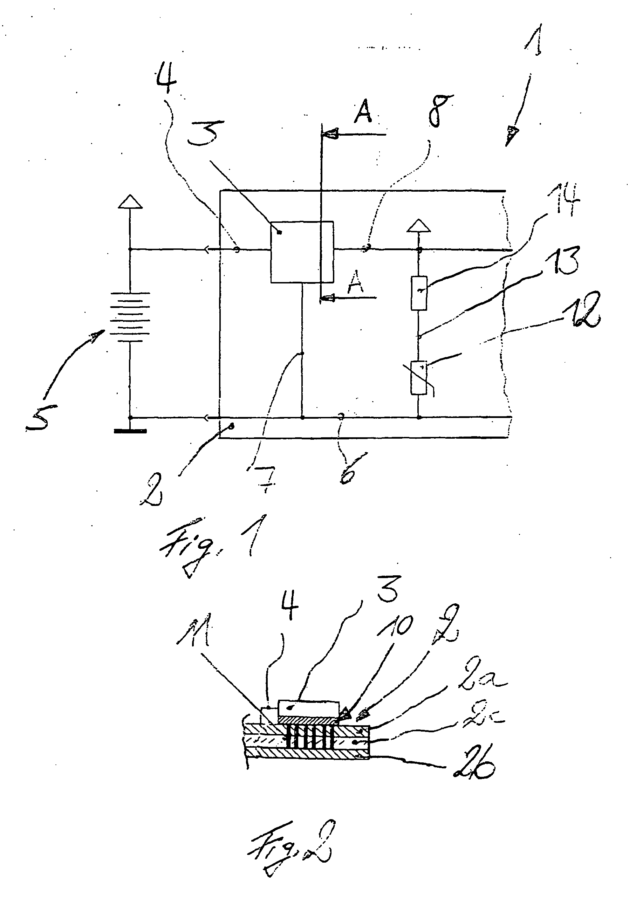

In der Figur 1 ist eine Draufsicht auf eine erfindungsgemäße Steuerelektronik 1 für ein Flurförderzeug, beispielsweise ein batterie-elektrisch betriebenes, deichselgeführtes Flurförderzeug, dargestellt. Die Steuerelektronik 1 ist als eine aus mehreren Leiterplattenschichten bestehende Platine 2 ausgebildet, die - wie aus der Figur 2 ersichtlich ist - eine obere Leiterplattenschicht 2a und eine untere Leiterplattenschicht 2b sowie eine zwischen der oberen Leiterplattenschicht 2a und der unteren Leiterplattenschicht 2b angeordnete Zwischenleiterplattenschicht 2c aufweist.

Die Steuerelektronik 1 umfasst einen Spannungswandler 3, der an der oberen Leiterplattenschicht 2a angeordnet ist. An der oberen Leiterplattenschicht 2a ist eine Leiterbahn 4 ausgebildet, mittels der die Eingangsseite des Spannungswandler 3 mit dem Pluspol einer als Batterie ausgebildeten Spannungsquelle 5 des Flurförderzeugs verbunden ist. Eine weitere Leiterbahn 6, die an der oberen Leiterplattenschicht 2a ausgebildet ist, steht mit dem Minuspol der Batterie 5 angeschlossen ist. Die Batterie 5 ist beispielsweise als 24V Batterie ausgeführt.

Der Spannungswandler 3 ist über eine Zweigleiterbahn 7 an die Leiterbahn 6 angeschlossen. An der oberen Leiterplattenschicht 2a ist weiterhin eine Leiterbahn 8 ausgebildet, die mit dem Ausgang des Spannungswandlers 3 in Verbindung steht und in der eine von dem Spannungswandler 3 erzeugte Nennspannung von beispielsweise 5V für die Versorgung der nicht mehr dargestellten Bauelemente der Steuerelektronik 1 ansteht.

Erfindungsgemäß ist in der Steuerelektronik 1 eine Heizeinrichtung 10 integriert. Die Heizeinrichtung 10 wird - wie in der Figur 2 gezeigt ist - von dem Spannungswandler 3 gebildet, der auf seiner Unterseite mit Verbindungsmitteln 11 versehen ist, die sich durch die obere Leiterplattenschicht 2a zu der Zwischenleiterplattenschicht 2c erstrecken. Die Verbindungsmittel 11 sind hierbei auf der Unterseite des Spannungswandlers 3 flächig verteilt und jeweils als elektrischer Leiter, beispielsweise als Rohre mit einer Kupferfüllung ausgebildet. Die Verbindungsmittel 11 stehen hierbei auf nicht mehr gezeigte Weise mit einer Leiterbahn bzw. mehreren Leiterbahnen der Zwischenleiterplattenschicht 2c in Verbindung.

Zur Steuerung der über die Verbindungsmittel 11 in die Zwischenleiterplattenschicht 2c eingebrachten Heizleistung des Spannungswandlers 3 ist ein Temperatursensor 12 vorgesehen. Der Temperatursensor 12 ist als PTC-Sensor ausgebildet, der in einer von der Leiterbahn 8 zur Leiterbahn 6 geführten Verbindungsleitung 13 angeordnet ist. Die Verbindungsleitung 13 ist beispielsweise auf der oberen Leiterplattenschicht 2a angeordnet. In der Verbindungsleitung 13 ist zudem ein in Reihe zu dem Temperatursensor 12 geschaltener Lastwiderstand 14 angeordnet.

Die Heizeinrichtung 10 der erfindungsgemäßen Steuerelektronik 1 arbeitet wie folgt:

Der Spannungswandler 3 erzeugt in der Leiterbahn 8 eine konstante Spannung von beispielsweise 5V. Der als PTC-Sensor ausgebildete Temperatursensor 12 erfasst die Umgebungstemperatur der Steuerelektronik 1 und weist bezüglich einer Bezugstemperatur bei einem Temperaturanstieg über die Bezugstemperatur einen erhöhten Innenwiderstand bzw. bei einem Temperaturabfall unter die Bezugstemperatur einen verringerten Innenwiderstand auf.

Bei einem Temperaturabfall unter die Bezugstemperatur und somit einem Abfall des Widerstands des PTC-Sensors steigt der Strom über den Lastwiderstand 14 und den PTC-Sensor 13 an. Hierdurch steigt ebenfalls die Leistung des Spannungswandlers 3 an, um die Spannung von 5V in der Leiterbahn 8 aufrechtzuerhalten. Die erhöhte Leistung des Spannungswandlers 3 wird hierbei über die Verbindungsmittel 11 als Heizleistung in die Zwischenleiterplattenschicht 2c eingeleitet. Durch die Verbindung der Verbindungsmittel 11 mit den inneren Leiterbahnen der Zwischenleiterplattenschicht 2c wird die Heizleistung über die Zwischenleiterplattenschicht 2c verteilt. Die Zwischenleiterplattenschicht 2c und die obere Leiterplattenschicht 2a sowie die untere Leiterplattenschicht 2b und somit die gesamte Platine 2 werden somit gleichmäßig aufgeheizt.

Steigt die Umgebungstemperatur über die Bezugstemperatur steigt der Widerstand des PTC-Sensors, wodurch der Strom über den Lastwiderstand 14 und den PTC-Sensor 13 sinkt. Hierdurch verringert sich die Leistung des Spannungswandlers 3, wodurch weniger Heizleistung in die Zwischenleiterplattenschicht 2c eingebracht wird.

Hierdurch wird ein Betrieb der Steuerelektronik 1 im Bereich der Bezugstemperatur bei im wesentlich konstanter Temperatur ermöglicht. Die Steuerelektronik 1 ist somit geringen Temperaturschwankungen ausgesetzt, wodurch eine verlängerte Lebensdauer der Steuerelektronik 1 erzielt werden kann. Die Heizeinrichtung 10 und der Temperatursensor 12 zur Regulierung der Heizleistung der Heizeinrichtung 10 sind vollständig in die Platine 2 integriert. Durch den einfachen und kostengünstigen Aufbau der Heizeinrichtung 10 kann eine erfindungsgemäße Steuerelektronik 1 als Standard für alle Anwendungen des Flurförderzeugs verwendet werden, wodurch für Kühlhausausführungen (Cold-Storage-Ausführungen) von Flurförderzeugen keine spezielle Steuerelektronik erforderlich ist.

## Patentansprüche

1. Steuerelektronik für ein Flurförderzeug, insbesondere deichselgeführtes Flurförderzeug, die elektrische und/oder elektronische Bauelemente und/oder Signalgeber umfasst, wobei die Steuerelektronik mit einer integrierten Heizeinrichtung versehen ist, die einen Betrieb der Steuerelektronik innerhalb eines Temperaturbereichs sicherstellt, **dadurch gekennzeichnet, dass** die Steuerelektronik (1) mit einem an eine Spannungsquelle (5), insbesondere eine Batterie, angeschlossenen Spannungswandler (3) versehen ist, der die Heizeinrichtung (10) bildet.

2. Steuerelektronik nach Anspruch 1, wobei die Steuerelektronik (1) als Platine (2) mit mehreren Leiterplattenschichten ausgebildet ist, **dadurch gekennzeichnet, dass** die Platine (2) zumindest eine zwischen einer oberen Leiterplattenschicht (2a) und einer unteren Leiterplattenschicht (2b) angeordnete Zwischenleiterplattenschicht (2c) aufweist, die zur Aufheizung mit dem Spannungswandler (3) in Verbindung steht.

3. Steuerelektronik nach Anspruch 2, **dadurch gekennzeichnet, dass** der Spannungswandler (3) mittels Verbindungsmitteln (11) mit der Zwischenleiterplattenschicht (2c) in Verbindung steht.

4. Steuerelektronik nach Anspruch 3, **dadurch gekennzeichnet, dass** die Verbindungsmittel (11) als zumindest ein elektrischer Leiter ausgebildet ist, der mit einer Leiterbahn der Zwischenleiterplattenschicht (2c) in Verbindung steht.

5. Steuerelektronik nach Anspruch 3, **dadurch gekennzeichnet, dass** der elektrische Leiter als metallisches Rohr mit einer Kupferfüllung ausgebildet ist.

6. Steuerelektronik nach einem der Ansprüche 1 bis 5, **dadurch gekennzeichnet, dass** zur Steuerung der Heizeinrichtung (10) ein Temperatursensor (12) vorgesehen ist.

7. Steuerelektronik nach Anspruch 6, **dadurch gekennzeichnet, dass** der Temperatursensor (12) als PTC-Sensor ausgebildet ist, der an der Platine (2) angeordnet ist.

8. Steuerelektronik nach Anspruch 7, **dadurch gekennzeichnet, dass** der PTC-Sensor mit zumindest einem Lastwiderstand (14) in Reihe geschalten ist.

9. Steuerelektronik nach Anspruch 8, **dadurch gekennzeichnet, dass** der PTC-Sensor über den Lastwiderstand (14) an die mit der von dem Spannungswandler (3) erzeugten Spannung beaufschlagten elektrischen Leiterbahn (8) angeschlossen ist.

10. Steuerelektronik nach einem der vorangegangenen Ansprüche, **dadurch gekennzeichnet, dass** die Steuerelektronik in einem Deichselkopf eines deichselgeführten Flurförderzeugs angeordnet ist.

## Claims

1. Control electronics for an industrial truck, in particular a drawbar-guided industrial truck, which include electrical and/or electronic components and/or signal transmitters, the control electronics being provided with an integral heating device, which ensures that the control electronics can be operated within a temperature range, **characterized in that** the control electronics (1) are provided with a voltage transducer (3) connected to a voltage source (5), in particular a battery, which forms the heating device (10).

2. Control electronics according to Claim 1, the control electronics (1) being designed as a printed circuit board (2) with multiple printed circuit board layers, **characterized in that** arranged between an upper printed circuit board layer (2a) and a lower printed circuit board layer (2b), the printed circuit board (2) has at least one intermediate printed circuit board layer (2c), which is connected to the voltage transducer (3) for the purpose of heating.

3. Control electronics according to Claim 2, **characterized in that** the voltage transducer (3) is connected to the intermediate printed circuit board layer (2c) using connection means (11).

4. Control electronics according to Claim 3, **characterized in that** the connection means (11) are designed in the form of at least one electrical conductor, which is connected to a conductor track of the intermediate printed circuit board layer (2c).

5. Control electronics according to Claim 3, **characterized in that** the electrical conductor is designed in the form of a metal tube with a copper filling.

6. Control electronics according to one of Claims 1 to 5, **characterized in that** a temperature sensor (12) is provided for controlling the heating device (10).

7. Control electronics according to Claim 6, **characterized in that** the temperature sensor (12) is designed as a PTC sensor, which is arranged on the printed circuit board (2).

8. Control electronics according to Claim 7, **characterized in that** the PTC sensor is connected in series with at least one load resistor (14).

9. Control electronics according to Claim 8, **characterized in that** the PTC sensor is connected via the load resistor (14) to the electrical conductor track (8), which is supplied with the voltage generated by the voltage transducer (3).

10. Control electronics according to one of the preceding claims, **characterized in that** the control electronics are arranged in a drawbar head of a drawbar-guided industrial truck.

## Revendications

1. Électronique de commande pour un chariot de manutention, notamment un chariot de manutention guidé par timon, qui comprend des composants et/ou des détecteurs électriques et/ou électroniques, l'électronique de commande étant munie d'un dispositif de chauffage intégré qui garantit un fonctionnement de l'électronique de commande au sein d'une plage de températures, **caractérisée en ce que** l'électronique de commande (1) est munie d'un convertisseur de tension (3) raccordé à une source de tension (5), notamment une batterie, lequel forme le dispositif de chauffage (10).

2. Électronique de commande selon la revendication 1, l'électronique de commande (1) étant réalisée sous la forme d'une carte (2) à plusieurs couches de circuit imprimé, **caractérisée en ce que** la carte (2) présente au moins une couche de circuit imprimé intermédiaire (2c) disposée entre une couche de circuit imprimé supérieure (2a) et une couche de circuit imprimé inférieure (2b), la au moins une couche de circuit imprimé intermédiaire étant en liaison avec le convertisseur de tension (3) en vue d'être chauffée.

3. Électronique de commande selon la revendication 2, **caractérisée en ce que** le convertisseur de tension (3) est en liaison avec la couche de circuit imprimé intermédiaire (2c) à l'aide de moyens de liaison (11).

4. Électronique de commande selon la revendication 3, **caractérisée en ce que** les moyens de liaison (11) sont réalisés sous la forme d'au moins un conducteur électrique qui est en liaison avec une piste conductrice de la couche de circuit imprimé intermédiaire (2c).

5. Électronique de commande selon la revendication 3, **caractérisée en ce que** le conducteur électrique est réalisé sous la forme d'un tube métallique rempli de cuivre.

6. Électronique de commande selon l'une des revendications 1 à 5, **caractérisée en ce qu'**un capteur de température (12) est prévu pour commander le dispositif de chauffage (10).

7. Électronique de commande selon la revendication 6, **caractérisée en ce que** le capteur de température (12) est réalisé sous la forme d'une sonde à CTP qui est montée sur la carte (2).

8. Électronique de commande selon la revendication 7, **caractérisée en ce que** la sonde à CTP est branchée en série avec au moins une résistance de charge (14).

9. Électronique de commande selon la revendication 8, **caractérisée en ce que** la sonde à CTP est raccordée par le biais de la résistance de charge (14) à la piste conductrice (8) électriquement sollicitée par la tension générée par le convertisseur de tension (3).

10. Électronique de commande selon l'une des revendications précédentes, **caractérisée en ce que** l'électronique de commande est montée dans une tête de timon d'un chariot de manutention guidé par timon.
